# EUROPEAN PATENT APPLICATION

(11) **EP 4 459 825 A1**
(43) Date of publication of application: **06.11.2024**
(21) Application number: 22914324.3
(22) Date of filing: 16.12.2022
(51) Int. Cl.: H02J 7/00, H05K 5/02, H05K 7/20

(54) **CHARGING DEVICE AND CHARGING SYSTEM**

(30) Priority: 30.12.2021 CN 202111655365; 30.12.2021 CN 202123443041 U; 30.12.2021 CN 202123437799 U; 30.12.2021 CN 202111650641
(71) Applicant: Globe (Jiangsu) Co., Ltd., Changzhou, Jiangsu 213023 (CN)
(72) Inventor: LU, Chuntao, Hangzhou, Jiangsu 213023 (CN); YAN, An, Hangzhou, Jiangsu 213023 (CN); HUO, Xiaohui, Hangzhou, Jiangsu 213023 (CN); NIE, Qiong, Hangzhou, Jiangsu 213023 (CN); ZHU, Yanqiang, Hangzhou, Jiangsu 213023 (CN)
(74) Representative: Bergenstråhle & Partners AB
(86) International application number: PCT/CN2022/139555
(87) International publication number: WO 2023/125070

(57) **Abstract**

A charging device includes a housing, a plurality of charging grooves, a handle, a first wheel and a supporting assembly. Wherein, the plurality of the charging grooves is arranged side by side inside the housing for accommodating an inserted battery pack. The handle is for a user to hold and is movably connected with the housing. The first wheel may be rotatably arranged at a bottom of the housing. The supporting assembly is arranged at the bottom of the housing. When the charging device is pulled, the handle is held, and the charging device is inclined and slides relative to a ground by the first wheel. When the charging device is placed horizontally, the first wheel and the supporting assembly are in contact with the ground.

## Description

### CROSS REFERENCE TO RELATED APPLICATION

The present application is a continuation Application of PCT application No. PCT/CN2022/139555 filed on December 16, 2022, which claims the benefit of CN202111655365.4 filed on December 30, 2021, CN202123443041.2 filed on December 30, 2021, CN202123437799.5 filed on December 30, 2021, and CN202111650641.8 filed on December 30, 2021. All the above are hereby incorporated by reference for all purposes.

### TECHNICAL FIELD

The disclosure relates to a technical field of battery pack charging, in particular to a charging device and a charging system.

### BACKGROUND

Garden tools are the maintenance device of human greening landscape. They are used to maintain lawns, hedges, protect flowers and trees, and are mechanized tools that replace most of manual labor and represented such as mowers, lawn mowers, string trimmers, etc. The battery pack provides power for garden tools and is a rechargeable power source. The battery pack charging device is used to charge the battery pack. The self-weight of conventional battery pack charging device is heavier, and even heavier after the battery pack put in, making difficult to be moved and not conducive for carrying. The conventional battery pack charging device has poor waterproof performance, which has the risk of leakage. As the charging efficiency of the charging device increases, the heat generated by the charging device itself is also increasing. If the heat generated during the charging process is not dissipated in time, it will lead to a heat accumulation and a rapid rise in the temperature of the battery pack, which will not only affect the charging efficiency of the battery pack, but also reduce the duration life of the battery pack, and has major safety risks.

### SUMMARY

The disclosure provides a charging device and a charging system to improve problems of handling difficulty, poor waterproof performance and low heat dissipation efficiency of conventional charging devices.

The disclosure provides the charging device and the charging system. The charging device includes a housing, a plurality of charging grooves, a handle, a first wheel and a supporting assembly. Wherein, the plurality of the charging grooves is arranged side by side inside the housing for accommodating an inserted battery pack. The handle is for a user to hold and is movably connected with the housing. The first wheel may be rotatably arranged at a bottom of the housing. The supporting assembly is arranged at the bottom of the housing. When the charging device is pulled, the handle is held, and the charging device is inclined and slides relative to a ground by the first wheel. When the charging device is placed horizontally, the first wheel and the supporting assembly are in contact with the ground.

In an embodiment of the disclosure, the housing is configured to a plurality of layers, at least two layers of the housing are provided with a corresponding vent sash, and a drainage assembly is arranged inside the layer of the housing corresponding to the vent sash.

In an embodiment of the disclosure, the at least two layers of the housing are arranged up and down to enable the drainage assemblies corresponding to each layer of the housing to be buckled up and down with each other, and a water outlet of the drainage assembly at a lower layer is communicated with an outside.

In an embodiment of the disclosure, the vent sashes include a plurality of mutually parallel inclined ribs arranged at equal intervals, and the inclined ribs are inclined downward by 35° to 50° from a horizontal plane.

In an embodiment of the disclosure, a limiting structure is arranged between the handle and the housing, the limiting structure includes a first limiting component and a second limiting component, the first limiting component is arranged on the handle, and the second limiting component is arranged on the housing and is matched with the first limiting component to realize a limitation to the handle. In an embodiment of the disclosure, the supporting assembly is a bracket, and a first side of the bracket is in contact with the ground, and a second side of the bracket is connected with the bottom of the housing. In an embodiment of the disclosure, the supporting assembly is a second wheel, and the second wheel is in a same direction with the first wheel and is arranged at intervals with the first wheel.

In an embodiment of the disclosure, the charging device further includes an auxiliary assembly, the auxiliary assembly is arranged at the bottom of the housing, when lifting, one end of the auxiliary assembly is in contact with the ground, and the end in contact with the ground is used as a fulcrum to cooperate with an external force to lift the charging device.

In an embodiment of the disclosure, the charging device further includes a charging module, a temperature sensor and a heat dissipation assembly. Wherein, the charging module is arranged in the housing, configured to obtain a first temperature of each battery pack after communicating with the inserted battery pack, and charge the battery pack according to the first temperature. The temperature sensor is arranged on the charging module and configured to obtain a second temperature of the charging module. The heat dissipation assembly is arranged inside the housing. The charging module is further configured to generate a control signal to the heat dissipation assembly according to the first temperature and/or the second temperature and control a startup or shutdown of the heat dissipation assembly.

In an embodiment of the disclosure, the charging module charges each battery pack according to the first temperature and is configured to:
start charging when the first temperature is greater than a low temperature threshold;
charge with a first current when the first temperature rises to a first temperature range;
charge with a second current when the first temperature rises to a second temperature range;
maintain a current total charging power unchanged and charge the battery pack with the first current when the first temperature of any battery pack rises to a first high temperature threshold; and
stop charging and alarm when the first temperature of any battery pack rises to a second high temperature threshold.

In an embodiment of the disclosure, the charging device is configured with a plurality of the charging modules, and each charging module is communicated with two battery packs at most and charges the at most two battery packs according to the first temperature of each battery pack obtained. Wherein, each charging mode is configured to
evenly distribute a charging power when an electric quantity difference between the two battery packs is less than a preset electric quantity; and
charge the battery pack having larger electric quantity preferentially and distribute larger power to the battery pack having larger electric quantity when the electric quantity difference between the two battery packs is greater than the preset electric quantity.

In an embodiment of the disclosure, the heat dissipation assembly includes a first fan, a second fan and a third fan.

The first fan is mounted between the opposite charging grooves in two adjacent rows, and configured to be started or shut down according to the control signal generated from the first temperature. Each first fan is configured to introduce airflow outside the housing into the charging groove through an air inlet on the housing for heat dissipation of a single battery pack.

The second fan is respectively arranged at two end parts of the housing, located on an inner side of the housing, and configured to export the airflow discharged by the first fan to an outside of the housing through an air outlet on the housing.

The third fan is respectively arranged on two sides of the charging module, and configured to be started or shut down according to the control signal generated from the second temperature.

In an embodiment of the disclosure, an airflow direction introduced by the first fan is perpendicular to an airflow direction exported by the first fan, and the first fans that dissipate heat for a same row of battery packs discharge airflows in a same direction, and the first fans that dissipate heat for two adjacent rows of battery packs discharge airflows in an opposite direction.

In an embodiment of the disclosure, the housing is further provided with vents. The vents are oppositely arranged on the housing and located at two sides of the charging module. The third fan is mounted between the vent and the charging module, and the airflow is introduced by the third fan from the vent on a first side and then exported by the third fan from the vent on a second side.

The disclosure further provides a charging system. The charging system includes the battery pack and the charging device.

The charging device is configured to charge the battery pack, and includes the housing, the plurality of charging grooves, the handle, the first wheel and the supporting assembly.

The plurality of charging grooves is arranged side by side inside the housing to accommodate the inserted battery pack.

The handle is for the user to hold and movably connected with the housing.

The first wheel is rotatably arranged at the bottom of the housing.

The supporting assembly is arranged at the bottom of the housing.

When the charging device is pulled, the handle is held, the charging device is inclined and slides relative to a ground by the first wheel. When the charging device is placed horizontally, the first wheel and the supporting assembly are in contact with the ground.

In summary, the charging device and the charging system of some embodiments of the disclosure have following beneficial effects:

The charging device of the disclosure is provided with the wheel at the bottom of the housing. Lifting handle can enable the charging device to move by a rolling of the first wheel, and a matching of the first wheel and the supporting assembly can enable the charging device to be placed stably, so the charging device of the disclosure can improve a problem that the conventional charging devices are difficult to carry. At the same time, the disclosure is provided with the charging module and the heat dissipation assembly. The first temperature of the battery pack and the second temperature of the charging module are detected in real time during charging, and the charging module charges the battery pack according to the first temperature. At the same time, the charging module further controls the heat dissipation assembly according to the first temperature and/or the second temperature, and the heat generated by the battery pack during the charging process is quickly and effectively dissipated to an outside of the housing, which effectively improves charging efficiency, prolongs a duration life of the battery pack, and realizes a harmonious compatibility of reducing energy consumption and charging safety.

### BRIEF DESCRIPTION OF THE DRAWINGS

In order to explain technical solutions of embodiments of the disclosure more clearly, the following will briefly introduce drawings used in a description of the embodiments or the conventional art. Obviously, the drawings in the following description are only some embodiments of the disclosure. For those of ordinary skill in the art, other drawings may be obtained based on these drawings without creative work.
FIG. 1 is a first schematic structural view of a charging device according to at least one embodiment of the disclosure.
FIG. 2 is a schematic structural view of the charging device after removing an upper cover according to at least one embodiment of the disclosure.
FIG. 3 is a schematic structural view of a battery cavity of the disclosure.
FIG. 4 is an exploded view of a housing of the disclosure.
FIG. 5 is a schematic structural view of a limiting structure of the disclosure.
FIG. 6 is a schematic structural view of a handle according to at least one embodiment of the disclosure.
FIG. 7 is an assembling view of a lower housing, a supporting assembly and a first wheel according to at least one embodiment of the disclosure.
FIG. 8 is a schematic structural view of a pulling rod in a first state of the disclosure.
FIG. 9 is a schematic structural view of the pulling rod in a second state of the disclosure.
FIG. 10 is a schematic structural view of the pulling rod in a third state of the disclosure.
FIG. 11 is a schematic structural view of a bottom of the housing according to at least one embodiment of the disclosure.
FIG. 12 is a partial enlarged view of area A in FIG. 12 of the disclosure.
FIG. 13 is a partial enlarged view of area B in FIG. 12 of the disclosure.
FIG. 14 is a partial enlarged view of area C in FIG. 12 of the disclosure.
FIG. 15 is a schematic structural view of a second stopping port at a first end of a middle housing of the disclosure.
FIG. 16 is a schematic structural view of a first vent sash according to at least one embodiment of the disclosure.
FIG. 17 is an exploded view of a lower housing and a circuit board shockproof assembly of the disclosure.
FIG. 18 is a schematic view of an angle γ of the disclosure.
FIG. 19 is a second schematic structural view of the charging device according to at least one embodiment of the disclosure.
FIG. 20 is a schematic structural view of an air inlet and a vent according to at least one embodiment of the disclosure.
FIG. 21 is a schematic structural view of a heat dissipation structure according to at least one embodiment of the disclosure.
FIG. 22 is a schematic structural view of a mounting window according to at least one embodiment of the disclosure.
FIG. 23 is a cross-sectional view of a second airflow generation device and an air outlet of the disclosure.
FIG. 24 is a schematic structural view of a charging module according to at least one embodiment of the disclosure.
FIG. 25 is a schematic view of an electrical connection of the charging device of the disclosure.

### PART NUMBER DESCRIPTION

10-charging device, 100-housing, 101-charging groove, 102-mounting window, 110-upper housing, 111-fourth shaft, 112-second limiting component, 113-connecting end, 1110-first airflow generation device, 1111-first fan mounting base, 1112-first fan, 1113-first flowing direction, 1114-second flowing direction, 1115-fan air inlet, 1116-fan air outlet, 1120-vent, 1121-first ventilation window, 1122-second ventilation window, 120-middle housing, 121-first vent sash, 1211-inclined rib, 1212-first flange, 130-lower housing, 131-second vent sash, 140-upper cover, 20-battery cavity, 200-heat dissipation structure, 201-air inlet, 202-air outlet, 203-second airflow generation device, 204-third airflow generation device, 210-charging module, 300-handle, 301-first limiting component, 302-first shaft, 310-handle body, 311-first holding part, 312-second holding part, 313-third holding part, 320-connecting rod, 321-first rod body, 322-second rod body, 400-first wheel, 401-second shaft, 500-supporting assembly, 510-bracket, 511-first bracket body, 512-second bracket body, 513-wear-resistant component, 520-second wheel, 521-third shaft, 600-auxiliary assembly, 601-first supporting leg, 602-pulling rod, 603-pulling button, 700-second supporting leg, 800-drainage assembly, 810-first water collection groove, 811-first water outlet, 812-first waterproof rib, 813-second water outlet, 820-second waterproof rib, 821-first separating rib, 822-first cavity space, 823-second cavity space, 830-through hole, 831-second flange, 840-second water collection groove, 841-third water outlet, 850-fourth waterproof rib, 860-first stopping port, 870-second stopping port, 880-third waterproof rib, 900-battery pack shockproof assembly, 1000-circuit board shockproof assembly.

### DETAILED DESCRIPTION

The following describes the implementation of the disclosure through specific embodiments, and those skilled in the art can easily understand other advantages and effects of the disclosure from the content disclosed in this specification. The disclosure may also be implemented or applied through other different specific embodiments. Various details in this specification may also be modified or changed based on different viewpoints and applications without departing from the disclosure. It should be noted that, the following embodiments and the features in the embodiments can be combined with each other without conflict. It should further be understood that the terms used in the examples of the disclosure are used to describe specific embodiments, instead of limiting the protection scope of the disclosure. The test methods that do not indicate specific conditions in the following examples are usually in accordance with conventional conditions, or conditions recommended by each manufacturer.

**It** should be noted that terms "upper", "lower", "left", "right", "middle" and "a/an" quoted in this specification are only for a convenience of description, and are not used to limit a scope of the disclosure. Changes or adjustments in their relative relationships shall also be regarded to be within the scope of the disclosure when there is no substantial change in the technical content.

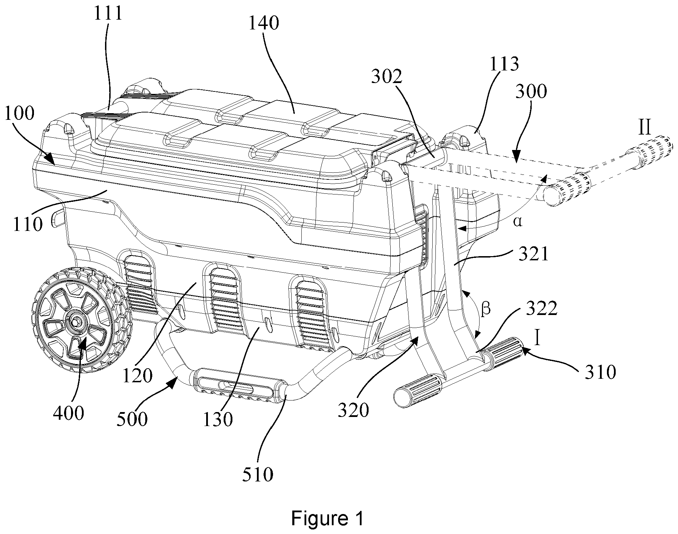

Please refer to FIG. 1 through FIG. 4. The disclosure provides a charging device. The charging device includes a housing 100, a handle 300, a first wheel 400 and a supporting assembly 500. In exemplary embodiments, a plurality of battery cavities 20 are arranged inside the housing 100, and a charging groove 101 is arranged in the battery cavity 20. The handle 300 is for a user to hold and is movably connected with the housing 100. The first wheel 400 is rotatably arranged at a bottom of the housing 100. The supporting assembly 500 is mounted at the bottom of the housing 100. When the charging device is pulled, the handle 300 is held, the charging device is inclined and slide relative to a ground by the first wheel 400. When the charging device is placed horizontally, the first wheel 400 and the supporting assembly 500 are in contact with the ground. The charging groove 101 is provided with a power connection terminal, and the power connection terminal is used for electrically connecting a battery pack and a circuit board assembly for charging. The handle 300 is located at a first end of the housing 100, and the first wheel 400 is located at the bottom of the housing 100. A distance between the first wheel 400 and a second end of the housing 100 is less than a distance between the first wheel 400 and the first end of the housing 100, and the first end is arranged opposite to the second end.

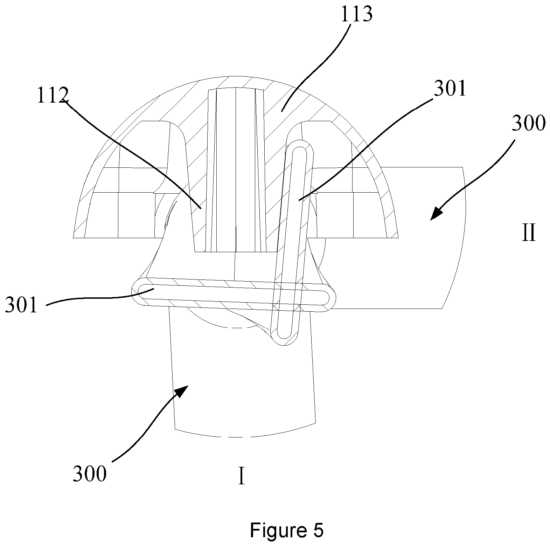

Please refer to FIG. 1 and FIG. 5. In an embodiment of the disclosure, a connecting end 113 is arranged on the housing 100, and part of the handle 300 is located inside the connecting end 113. A limiting structure is arranged between the handle 300 and the connecting end113. The limiting structure includes a first limiting component 301 and a second limiting component 112. The first limiting component 301 is arranged on the handle 300, and the second limiting component 112 is arranged on an inner wall of the connecting end 133 and is matched with the first limiting component 301. The first limiting component 301 is used together with the second limiting component 112, so that the handle 300 can only rotate within an allowable angle range. The handle 300 includes a handle body 310, a connecting rod 320 and a first shaft 302. The handle body 310 is fixedly connected with the first shaft 302 through the connecting rod 320.

In an embodiment of the disclosure, the first limiting component 301 is a limiting protrusion, the second limiting component 112 is a limiting groove, and these two are matched with each other to realize a groove limitation.

Please refer to FIG. 5. In an embodiment of the disclosure, the first limiting component 301 is a sheet-like structure, and the second limiting component 112 is a limiting rib, and the limiting rib is arranged on the inner wall of the connecting end 113. Advantages of the sheet-like limiting structure and the limiting rib are simple structure, saving materials, high strength, good stability, and good limiting effect.

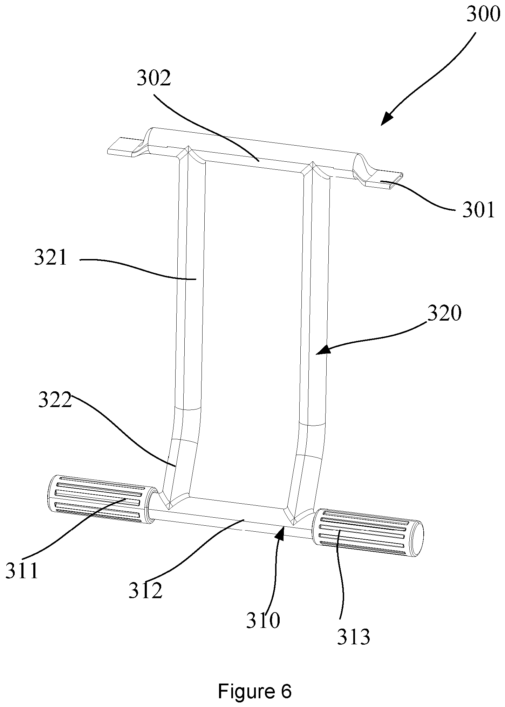

Please refer to FIG. 6. The first limiting component 301 is arranged on at least one end part of the first shaft 302, and the first limiting component 301 and the first shaft 302 may be integrally formed. An integrated structure has advantages of easy processing and high strength.

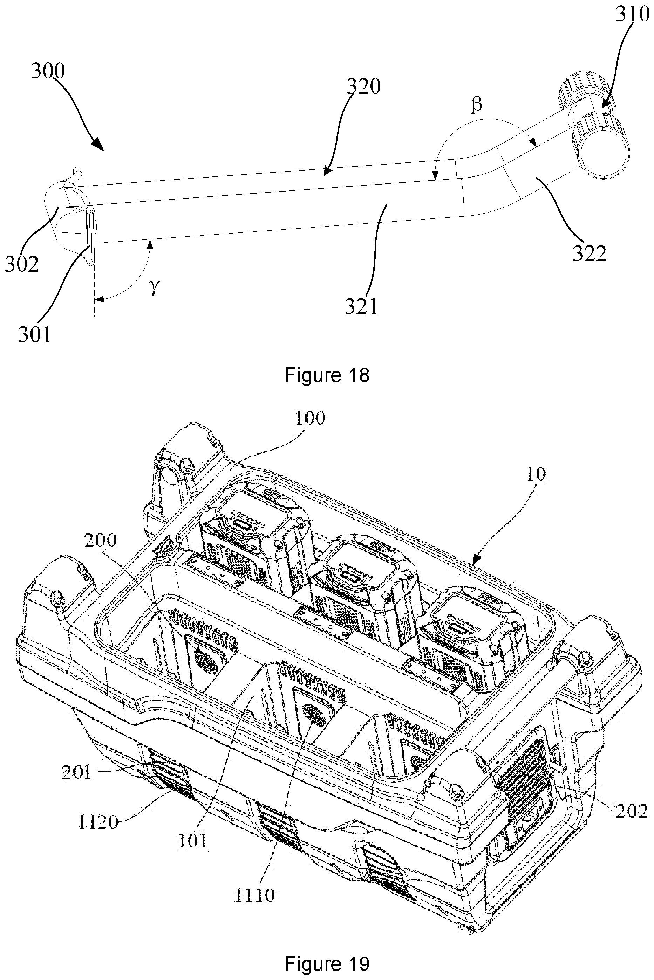

Please refer to FIG. 1. In an embodiment of the disclosure, an initial position of the handle 300 is a first position, and a limiting position of the handle 300 is the second position. An angle α between the first position and the second position of the handle 300 is from 80 degrees to 120 degrees, and the handle 300 can be arbitrarily rotated with the first shaft 302 as a fulcrum between the first position and the second position. This rotation angle α refers to an angle between an initial state of the handle and an ending state of the handle, and the initial state refers to a state when the handle 300 in a non-working state is in a position where it should be placed, such as a position I in FIG. 1. The ending state refers to a state when the handle 300 is rotated to the limiting position, such as the position II in FIG. 1. The handle 300 may be rotated from 0 degrees to α at will between the first position and the second position. It should be noted that, for a certain finished handle 300, its maximum rotation angle is fixed. Please refer to FIG. 18. If the maximum rotation angle of the handle 300 needs to be adjusted, the angle γ between the first limiting component 301 and the connecting rod 320 needs to be adjusted before the handle 300 is manufactured. Through adjusting the angle γ, the allowable rotation angle α of the handle 300 may reach 80 degrees to 120 degrees.

Please refer to FIG. 1. In an embodiment of the disclosure, the connecting rod 320 includes a first rod body 321 and a second rod body 322. The first rod body 321 is smoothly connected with the second rod body 322, and a range of an angle β between the first rod body 321 and the second rod body 322 is: 110 degrees≤β≤ 180 degrees. The first rod body 321 and the second rod body 322 are integrally formed or welded structures. Since the angle β is within this angle range, it is easier for a conveyor to apply force during a handling of the charging device and is conducive to increasing a comfort of the conveyor.

Please refer to FIG. 6. In an embodiment of the disclosure, the handle 300 includes two connecting rods 320. The two connecting rods 320 divide the handle body 310 into a first holding part 311, a second holding part 312, and a third holding part 313. A length of the second holding part 312 is from 5cm to 15 cm, and a length of the first holding part 311 and/or the third holding part 313 is from 5cm to 12 cm. The above length setting range meets needs of human palms, which is conducive to further improving a sense of use. The first holding part 311 and/or the third holding part 313 are provided with anti-slip sleeves, and anti-slip lines are arranged on the anti-slip sleeves.

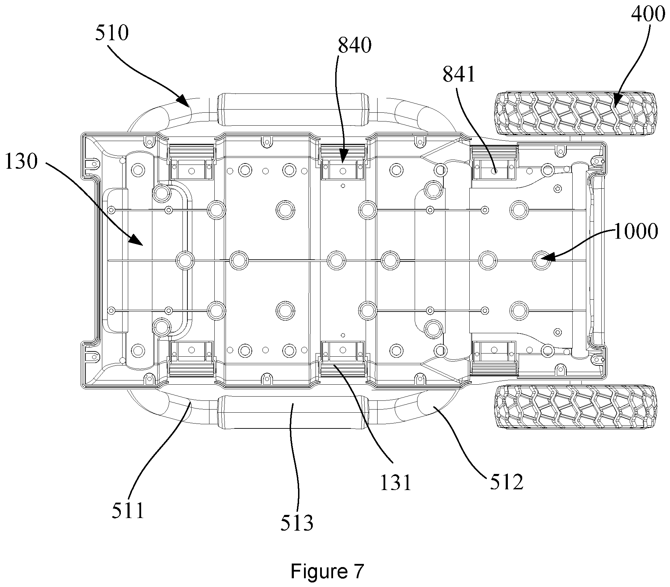

Please refer to FIG. 1 and FIG. 7. In an embodiment of the disclosure, the wheel 400 is detachably mounted at the bottom of the housing. The wheel 400 and the housing 100 are detachably mounted to facilitate a disassembly and subsequent maintenance. Users may choose to remove the wheel 400 from the housing according to their own needs (such as a need to store the charging device fixedly).

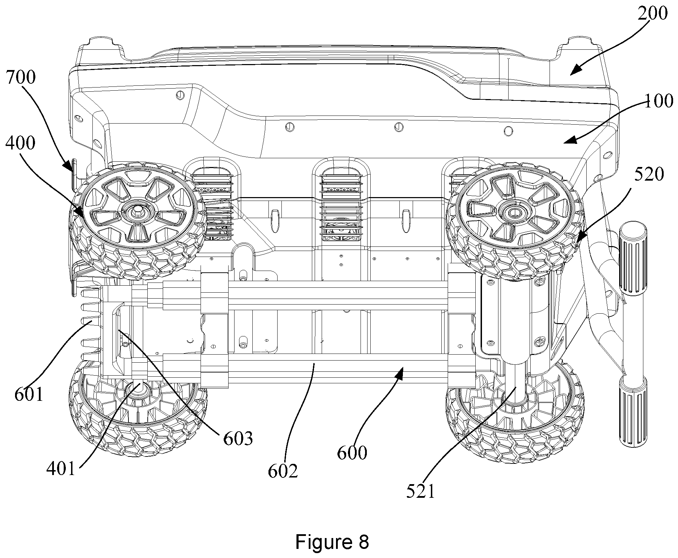

Please refer to FIG. 8. In an embodiment of the disclosure, the charging device includes two first wheels 400. A second shaft 401 is arranged between the two first wheels 400, the second shaft 401 is rotatably connected with the first wheel 400, and the second shaft 401 is detachably mounted at the bottom of the housing 100. The bottom of the housing 100 is provided with a first mounting groove for accommodating the second shaft 401, and the second shaft 401 may be rotated in the first mounting groove.

In an embodiment of the disclosure, the first wheel 400 is connected with the second shaft 401 through a ball bearing. The ball bearing may provide a certain amount of flexible moving space for the wheels, so as to have a certain buffering effect and achieves a shock-absorbing effect. When the handle is lifted, only the first wheel of the whole charging device may be in contact with the ground, and rest of the charging device is out of the ground. Through pulling the handle, the first wheel may be dragged to rotate and the charging device may be easily handled.

In an embodiment of the disclosure, the first wheel 400 may further be a directional wheel or a universal wheel that is directly mounted at a rear end of the bottom of the housing 100.

Please refer to FIG. 1. In an embodiment of the disclosure, the supporting assembly 500 is detachably mounted at the bottom of the housing 100. A detachable mounting enables the supporting assembly 500 to be more flexible in a process of use, and the user may disassemble and assemble the supporting assembly 500 according to their actual needs.

In an embodiment of the disclosure, the supporting assembly 500 is a bracket 510, and a first side of the bracket 510 is in contact with the ground, and a second side of the bracket 510 is connected with the bottom of the housing 100. A width of the bracket 510 is less than a maximum wheel base of the first wheels 400. The width of the bracket 510 refers to a maximum size of the bracket 510 in a direction parallel to the second shaft 401, and the wheel base of the wheels 400 refers to a distance between the two first wheels. The first side of the bracket 510 is in a point contact or continuous interface contact with the ground. A wear-resistant component 513 is arranged on the first side of the bracket 510. When the charging device is placed horizontally, the wear-resistant component 513 is in contact with the ground.

Please refer to FIG. 7. In an embodiment of the disclosure, the bracket 510 includes a first bracket body 511 and a second bracket body 512. The first bracket body 511 is connected with the second bracket body 512 through the wear-resistant component 513, the wear-resistant component 513 is detachably connected with the first bracket body 511, and the wear-resistant component 513 is detachably connected with the second bracket body 512.

In an embodiment of the disclosure, the bracket 510 is an integral forming structure, and wear-resistant components 513 are arranged on two sides of the bracket 510. The wear-resistant component 513 may be a rubber ring, and a function of the rubber ring is wear-resistant buffering, which can effectively improve a duration life of the bracket 510.

Please refer to FIG. 8. In an embodiment of the disclosure, the supporting assembly 500 is a second wheel 520, and the second wheel 520 is in a same direction with the first wheel 400 and is arranged at intervals with the first wheel 400. The first wheel 400 and the second wheel 520 can be used together to enable the charging device be placed smoothly, which means placed laterally, and the charging device can be moved smoothly. In this embodiment, there are two ways to move the charging device through the wheel. A first way is to lift the handle 300, so that only the first wheel 400 of the whole charging device is in contact with the ground, and the charging device is moved through the first wheel 400. A second way is to enable the first wheel 400 and the second wheel 520 to be both in contact with the ground, and pull the handle 300 or push the housing 100, and the charging device is moved through the first wheel 400 and the second wheel 520.

Please refer to FIG. 8. In an embodiment of the disclosure, the second wheel 520 includes two second wheels 520 and a third shaft 521. The two second wheels 520 are rotatably mounted on the third shaft 521, and the third shaft 521 is detachably mounted at the bottom of the housing.

**In** an embodiment of the disclosure, the ball bearing is arranged between the third shaft 521 and the second wheel 520. The ball bearing may provide the certain amount of flexible moving space for the wheels, so as to have the certain buffering effect and achieves the shock-absorbing effect.

Please refer to FIG. 8 through FIG. 10. In an embodiment of the disclosure, the charging device further includes an auxiliary assembly 600. The auxiliary assembly 600 is detachably mounted at the bottom of the housing 100. When lifting, one end of the auxiliary assembly 600 is in contact with the ground, and this end in contact with the ground is used as the fulcrum to cooperate with an external force to lift the charging device. The auxiliary unit 600 is used to assist the user in moving the charging unit to a target position with a height difference, for example, from the ground to a vehicle.

Please refer to FIG. 8 through FIG. 10. In an embodiment of the disclosure, the auxiliary assembly 600 includes a plurality of first supporting legs 601 and a pulling rod 602. The plurality of first supporting legs 601 are arranged in an array on a side of the pulling rod 602 in contact with the ground. The pulling rod 602 is horizontally mounted at the bottom of the housing 100 and can be pulled along the horizontal direction. An inner side of an end part of the pulling rod 602 is provided with a pulling button 603, and a pulling of the pulling rod 602 may be realized through the pulling button 603. When the charging device needs to be moved to a certain height or on the vehicle, the pulling rod 602 is pulled out, and the housing is lifted, so that the first supporting leg 601 is supported on the ground, then the housing continues to be lifted to the target height, which enables the bottom of the housing or the first wheel to contact with a storage object or a vehicle body (if necessary, the charging device may be dragged). Then the housing is pressed, so that the charging device is carried to the target height or the vehicle, and this process saves time and effort, and improves a convenience of use.

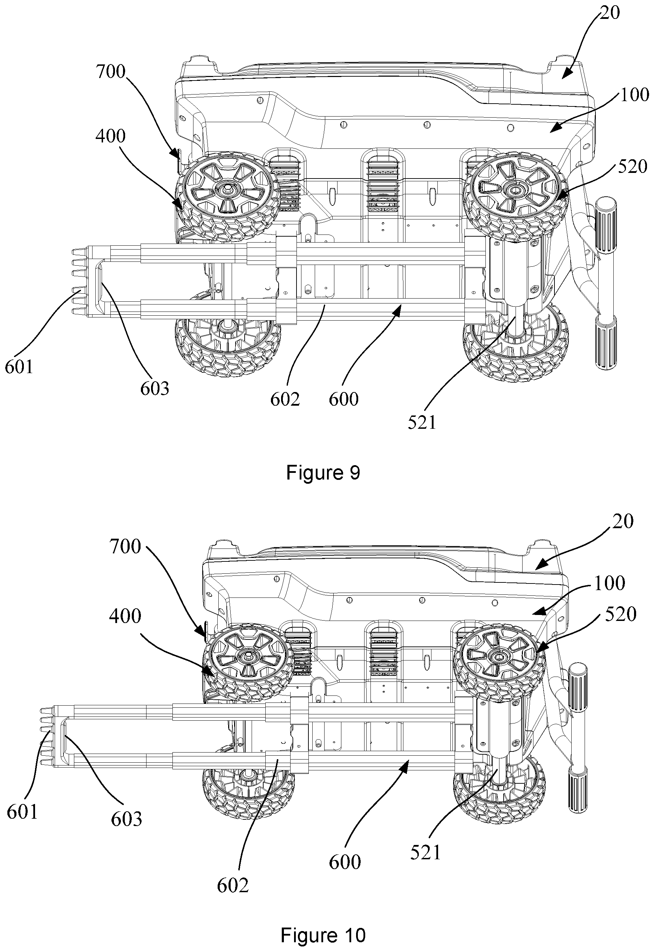

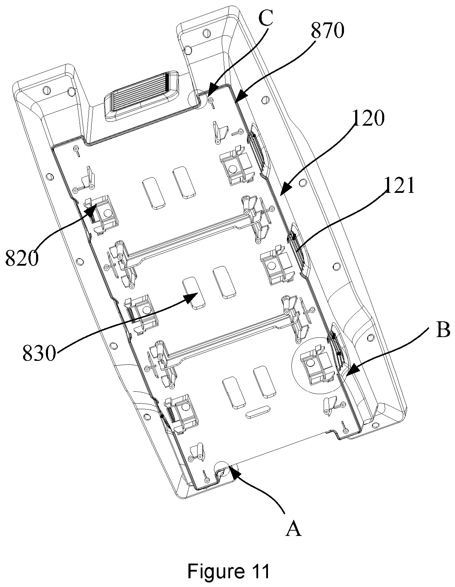

Please refer to FIG. 8 through FIG. 10. In an embodiment of the disclosure, the pulling rod 602 is at least provided with a first state, a second state and a third state, which means that when the pulling rod 602 is in the initial state, or when it is pulled to a first length, or when it is pulled to a second length, the pulling rod 602 is in a locked state. Wherein, when the pulling rod 602 is in the first state, please refer to FIG. 9. When the pulling rod is in the second state, please refer to FIG. 10. When the pulling rod 602 is in the third state, please refer to FIG. 11.

Please refer to FIG. 8 through FIG. 10. In an embodiment of the disclosure, the charging device further includes a second supporting leg 700. The second supporting leg 700 is arranged at a side surface of the housing 100 at an end of the first wheel 400. The charging device is placed stably under a matching of the first wheel 400 and the second supporting leg 700, which means vertically. In addition, an outer end face of the housing 100 may be tangent to a peripheral end face of the first wheel 400, which means that when the charging device is placed vertically, the outer end face of the housing 100 and the first wheel 400 are both in contact with the ground, and the charging device may also be placed smoothly.

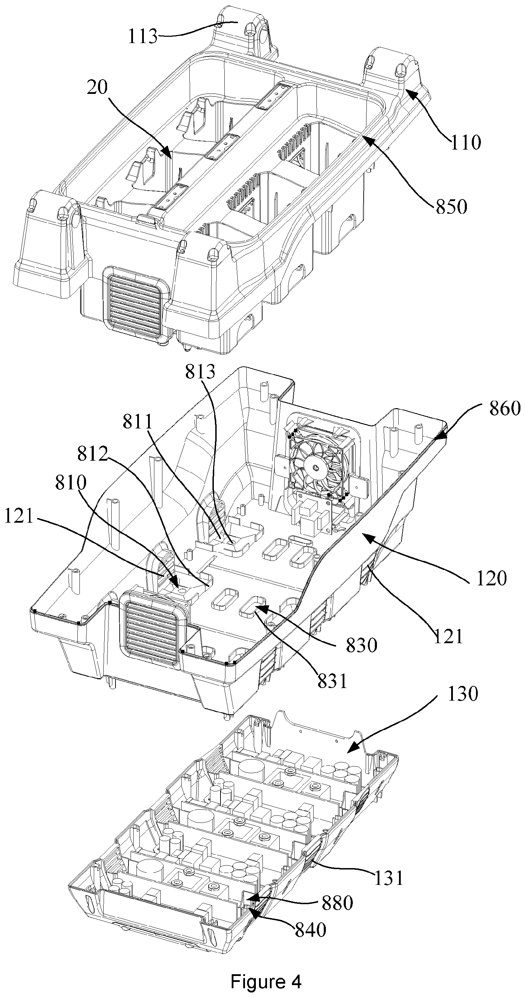

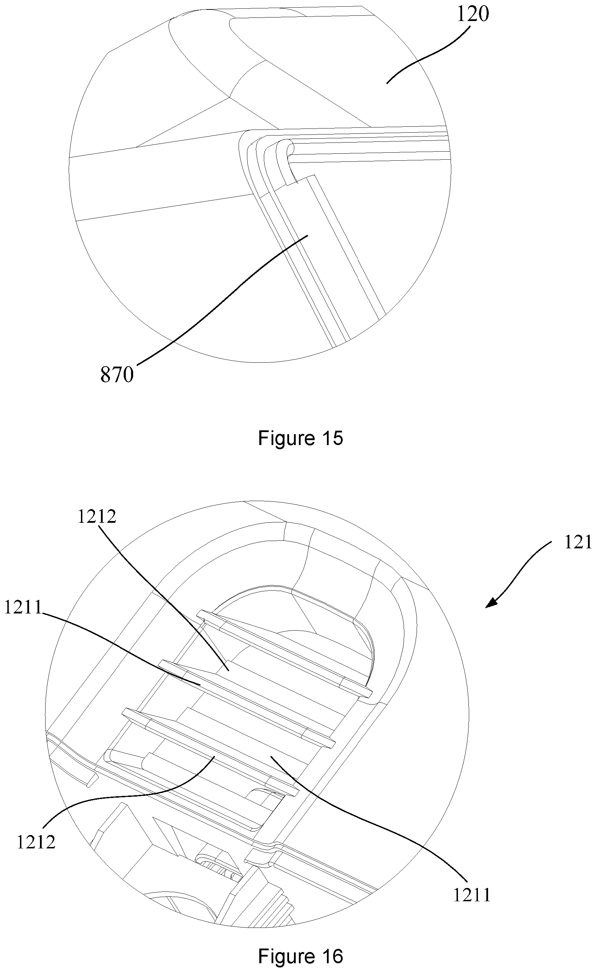

Please refer to FIG. 4 and FIG. 16. In an embodiment of the disclosure, the charging unit further includes a drainage assembly 800 arranged in the housing. The drainage assembly 800 includes a first drainage assembly and a second drainage assembly arranged in the housing. The housing 100 includes an upper housing 110, a middle housing 120 and a lower housing 130 that are successively mounted together from top to bottom, and the battery cavity 20 is located inside the upper housing 110. The middle housing 120 and the lower housing 130 are correspondingly provided with a first vent sash 121 and a second vent sash 131. A plurality of groups of first vent sashes 121 are oppositely arranged on the middle housing 120, and a first drainage assembly is arranged inside the middle housing 120 corresponding to each first vent sash 121.

In an embodiment of the disclosure, the first vent sash 121 and the second vent sash 131 include a plurality of mutually parallel inclined ribs 1211 arranged at equal intervals, and the inclined ribs are inclined downward by 35° to 50° from a horizontal plane. High side edges of at least part of the inclined ribs in the first vent sash 121 and the second vent sash 131 extend upwards to form a first flange 1212.

In an embodiment of the disclosure, the first drainage assembly includes a first water collection groove 810. The first water collection groove 810 is arranged at a bottom of the middle housing 120 and is located at a side of the first vent sash 121. A first water outlet 811 is arranged on the first water collection groove 810, and the first water outlet 811 is in contact with a side wall of the middle housing 120, which means that one edge of the first water outlet 811 is located on the inclined rib 1211 or an inner wall of the first flange 1212 of the first vent sash 121.

Please refer to FIG. 4. In an embodiment of the disclosure, the first water collection groove 810 further includes a first waterproof rib 812. The first waterproof rib 812 is arranged on a side of the middle housing 120 facing the upper housing 110 and located at an edge of the first water collection groove 810. A plurality of first openings is arranged in the first waterproof rib 812. The first openings facilitate water to flow into the first collection groove. A bottom of the first collection groove 810 is further provided with a second water outlet 813, and a bottom surface of the first collection groove 810 is inclined towards the first water outlet 811.

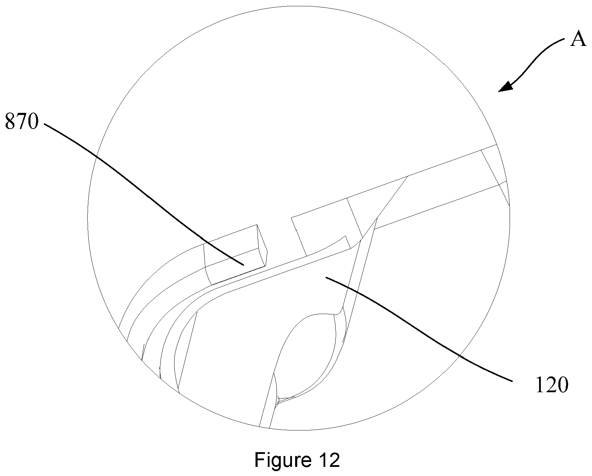

Please refer to FIG. 4, FIG. 11, FIG. 12 and FIG. 13. In an embodiment of the disclosure, the first drainage assembly 800 further includes a second waterproof rib 820 and a through hole 830. The second waterproof rib 820 is arranged on one side of a bottom of the first water collection groove facing the lower housing, and a first separating rib 821 is arranged inside the second waterproof rib 820. The first separating rib 821 isolates an area enclosed by the second waterproof rib 820 as a first cavity space 822 and a second cavity space 823, and the first cavity space 822 is communicated with the first water outlet 811 and opens towards the lower housing 130. The first cavity space 822 further opens toward an adjacent side wall of the middle housing 120. The second cavity space 823 is communicated with the second water outlet 813 and opens towards the lower housing 130, and end surfaces of the first separating rib 821 and the second waterproof rib 820 parallel to the first separating rib are cylindrical surfaces. The through hole 830 is arranged at the bottom of the middle housing 120, a periphery of the through hole 830 is spread over the second flange 831, the second flange 831 faces toward the upper housing 110, and a power connection terminal of the battery pack is located outside the second flange 831.

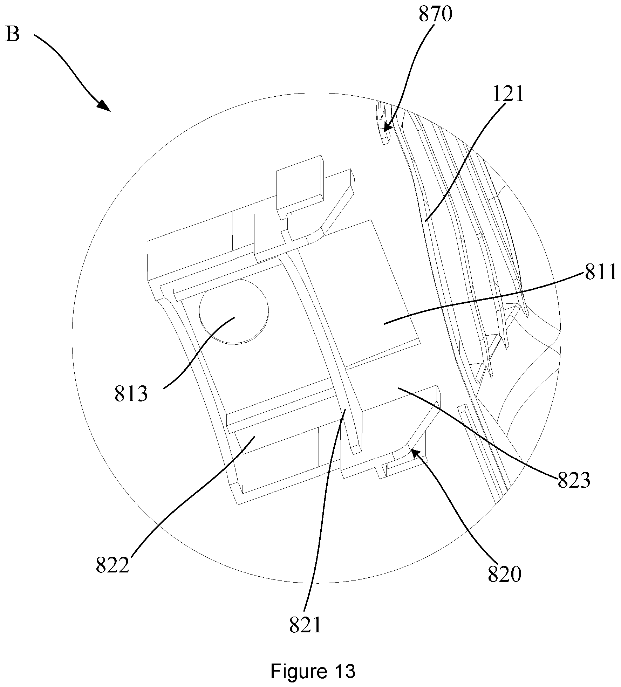

Please refer to FIG. 4 and FIG. 13. In an embodiment of the disclosure, the lower housing 130 is provided with a plurality of groups of second vent sashes 131 arranged oppositely. The lower housing 130 corresponding to each second vent sash 131 is internally provided with a second drainage assembly, and the first drainage assembly and the second drainage assembly are buckled up and down. A water outlet of the second drainage assembly is communicated with an outside, so that the second drainage assembly receives accumulated water discharged by the first drainage assembly and discharges the water through the water outlet of the second drainage assembly. The second drainage assembly 800 includes a second water collection groove 840 and a third waterproof rib 880. The second water collection groove 840 is arranged at a bottom of the lower housing 130 and located at a side of the second vent sash 131. A periphery of the second water collection groove 840 is provided with a third waterproof rib 880, the second waterproof rib 820 is buckled with the third waterproof rib 880, and a bottom of the second water collection groove 840 is provided with a plurality of third water outlets 841 that are communicated with the outside.

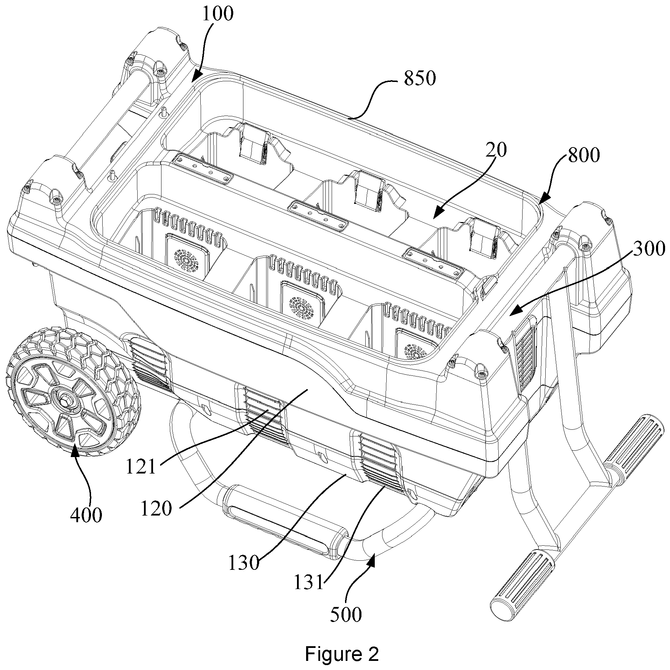

Please refer to FIG. 2. In an embodiment of the disclosure, the charging device further includes a fourth waterproof rib 850. The fourth waterproof rib 850 is arranged on the upper housing 110 and is spread all over an edge of the battery cavity 20. The fourth waterproof rib 850 protrudes from a contacting end face between the battery cavity 20 and the upper housing 110, which establishes a waterproof wall, thereby playing a role of waterproofing at a joint.

Please refer to FIG. 4. In an embodiment of the disclosure, the charging device further includes a first stopping port 860. The first stopping port 860 is arranged on an upper edge of the middle housing 120 and is spread across a joint between the upper housing 110 and the middle housing 120. The first stopping port 860 forms the waterproof wall at a contacting point between the middle housing 120 and the upper housing 110, thereby playing the role of waterproofing.

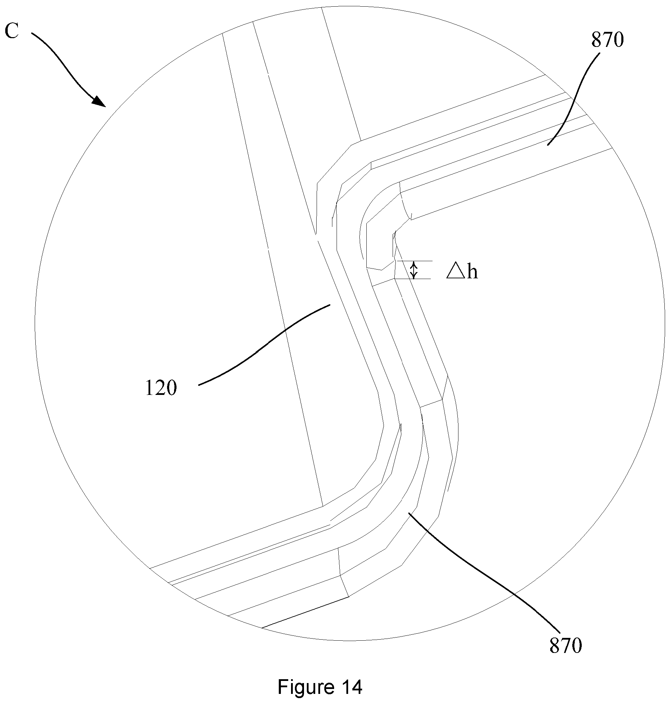

Please refer to FIG. 11 through FIG. 15. In an embodiment of the disclosure, the charging device further includes a second stopping port 870. The first second port 870 is arranged on the middle housing 120 and is located at a joint between the middle housing 120 and the lower housing 130. And the second stopping port 870 partially covers the joint between the middle housing 120 and the lower housing 130. For example, the joint of the middle housing 120 and the lower housing 130 and a top of the second water collection groove 840 (or the upper edge of the second vent sash) are not provided with the second stopping port 870, so that water may flow into the second collection groove 840 at a position where there is no second stopping port 870, and flow out from an outlet of the second collection groove 840. A rib height at a position where the second stopping port 870 is located at a first end part of the lower housing 130 is lower than a rib height at other places, and the first end part of the lower housing 130 is an end that is closer to the handle.

Please refer to FIG. 4. In an embodiment of the disclosure, there are six charging grooves 101 arranged in the battery cavity 20, there are six first water collection grooves 810 arranged at the bottom of the middle housing 120. The first water outlets 811 of the six collection grooves are arranged at an edge of the side wall of the middle housing 120, which helps to increase a drainage speed.

Please refer to FIG. 1. In an embodiment of the disclosure, a fourth axis 111 is arranged on the upper housing 110. The housing 100 further includes an upper cover 140, and the upper cover 140 is rotatably mounted on the fourth axis 111. In addition to the above-mentioned carrying mode of the charging device, the user may also manually carry the charging device by holding the fourth shaft 111 and the first shaft 302.

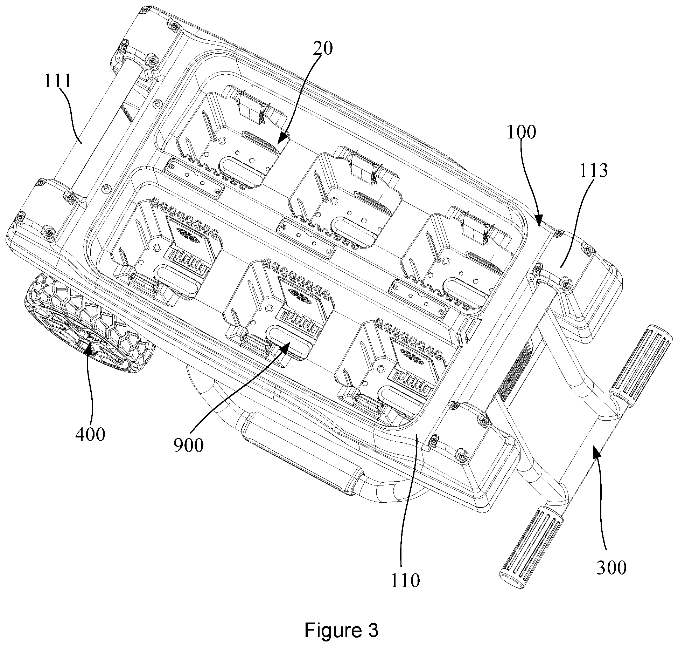

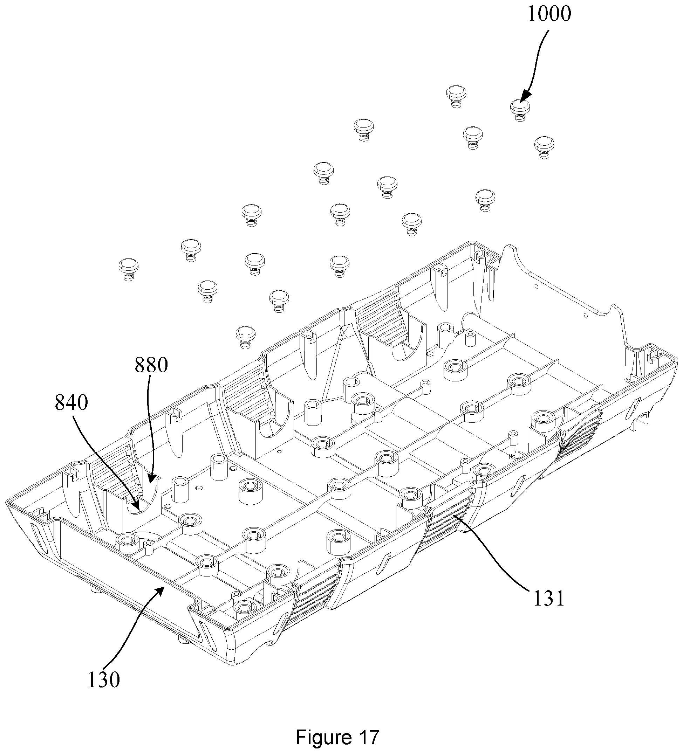

Please refer to FIG. 3 and FIG. 17. In an embodiment of the disclosure, the charging device further includes a battery pack shockproof assembly 900 and a circuit board shockproof assembly 10000. The battery pack shockproof assembly 900 is arranged in the battery cavity 20 and located below the battery pack. The battery pack shockproof assembly 900 includes a plurality of springs and a spring cover, the plurality of springs are arranged at a bottom of the battery cavity and are located inside the spring cover. The circuit board shockproof assembly 1000 includes a plurality of springs and elastic pads arranged in pairs, and one end of the elastic pad is open to accommodate the springs.

Please refer to FIG. 19 through FIG. 21. The disclosure provides the charging device 10. The charging device 10 includes the housing 100, the plurality of charging grooves 101, a heat dissipation structure 200 and a charging module 210. Wherein, the heat dissipation structure 200 includes a heat dissipation assembly. When the battery pack is inserted in the charging groove 101, the charging module 210 is in a communication connection with the inserted battery pack, obtains a first temperature of each battery pack, and charges the battery pack according to the first temperature. The charging module 210 is provided with at least one temperature sensor. Each temperature sensor transmits an obtained second temperature of the charging module 210 to the charging module 210. The charging module 210 is further used for generating a control signal according to the first temperature and/or the second temperature, and this control signal is output to the heat dissipation assembly to control a startup or shutdown of the heat dissipation assembly, so that heat generated by the battery pack in a charging process is quickly and efficiently dissipated to an outside of the housing 100. It should be understood that the battery pack involved in the disclosure is provided with a communication function, and each battery pack is provided with a BMS battery management system. The BMS battery management system may obtain current, voltage and temperature parameters of the battery pack, and transmit them to the charging module 210 in real time. In addition, the charging module 210 includes a processing chip with the communication function and a peripheral circuit, and corresponding operations may be performed through the charging module 210 according to a pre-stored program.

A structure and a working principle of the charging device 10 are described in detail below.

The charging grooves 101 are arranged side by side inside the housing 100 to accommodate the inserted battery pack. In an embodiment of the disclosure, there are six charging grooves 101, which may accommodate six battery packs. Correspondingly, the charging device 10 is configured with a plurality of charging modules 210, and each charging module 210 is in a communication connection with two battery packs at most, and charging the at most two battery packs according to the first temperature of each battery pack obtained. The six battery packs may be charged and controlled by three charging modules 210.

Further, when the charging module 210 charges two battery packs simultaneously, if an electric quantity electric quantity difference of the two battery packs is less than a preset electric quantity, which means that the electric quantity electric quantity difference of the two battery packs is smaller or the electrical quantities of the two battery packs are the same, then a charging power is evenly distributed. If the electric quantity electric quantity difference of the two battery packs is greater than the preset electric quantity electric quantity difference, which means that the power difference of the two battery packs is larger, then the battery pack having larger electric quantity electric quantity is preferentially charged, and a larger charging power is distributed to it, such as two thirds of the charging power.

Further, after the charging module 210 obtains the first temperature of the battery pack and adjusts the corresponding charging current according to a temperature range, thereby controlling the charging power under different temperature conditions. Specifically, the charging module 210 charging each battery pack according to the first temperature includes:
starting charging when the first temperature is greater than a low temperature threshold;
charging with a first current when the first temperature rises to a first temperature range;
charging with a second current when the first temperature rises to a second temperature range;
maintaining a total power of the current charging unchanged and charging the battery pack with the first current when the first temperature of any battery pack rises to a first high temperature threshold; and
stopping charging and alarming when the first temperature of any battery pack rises to a second high temperature threshold.

It should be understood that a too low or too high temperature will affect a performance of the battery pack, and charging the battery pack at a low temperature or a high temperature may cause damage to the battery pack and shorten a duration life of the battery pack. Specifically in this embodiment:
The low temperature threshold is set to 0 degree. When the first temperature is lower than 0 degree, the charging will not be performed.

A first temperature range is set to be 0 degree to 5 degrees, in this range, a first current is adopted for charging. The first current may be set according to a need, and the first current in this embodiment does not exceed 2A. At this time, if a rated voltage of a single battery pack is 80V, the charging current of the two battery packs is 1A respectively, a charging power of a single charging module 210 is up to 80*2=160W, and a charging total power of the three charging modules 210 is up to 480W.

A second temperature range is set to be 5 degrees to 45 degrees, in this range, a second current is adopted for charging. The second current in this embodiment is 6A. At this time, the charging current of the two battery packs is 3A respectively, the charging power of the single charging module 210 is up to 80*6=480W, and the charging total power of the three charging modules 210 is up to 1440W.

A first high temperature threshold is set to be 45 degrees. When the first temperature of any battery pack reaches 45 degrees, on a premise of maintaining the current charging total power unchanged, a small current is adopted to charge this battery pack. Simultaneously, more charging current is adopted to charge the battery pack with a normal temperature. In this embodiment, the first current such as 2A is used to charge the battery pack with a higher temperature, and the current such as 4A is used to charge the battery pack with the normal temperature. At this moment, the charging power of the single charging module 210 is up to 80*(2+4)=480 W, the total charging power of the three charging modules 210 is up to 1440W. Until the first temperature of the battery pack is reduced to a second temperature range, the charging current of each battery pack is configured to be 3A.

The second high temperature threshold is set to 55 degrees. When the first temperature of any battery pack reaches 55 degrees, in order to ensure a charging safety of the battery pack, the charging should be stopped immediately and an alarm should be given, and until the temperature of the battery pack is reduced to a normal range, the charging module 210 resumes charging again.

In order to control a rising temperature when the battery pack is charged, the charging device 10 of the disclosure includes the heat dissipation structure 200, which is used for dissipating the heat generated by the battery pack in the charging process quickly and effectively to the outside the housing 100, wherein:
the heat dissipation structure 200 is configured to dissipate heat for each battery pack. The heat dissipation structure 200 includes an air inlet 201, an air outlet 202, a vent 1120, a first airflow generation device 1110 and a second airflow generation device 203. The air inlet 201 is arranged on the housing 100 for airflow to enter. The air outlet 202 is arranged on the housing 100 for airflow to flow out. The vent 1120 are oppositely arranged on the housing 100 and located on two sides of the charging module 210. The first airflow generation device 1110 is arranged in the housing 100 and is located between two opposite charging grooves 101 of two adjacent rows. Part or all of the airflow entering from air inlet 201 is driven by the first airflow generation device 1110 and is sucked by the first airflow generation device 1110 after flowing through the charging groove, and then discharged by the first airflow generation device 1110. The second airflow generation device 203 is arranged in the housing 100, and guides the airflow discharged by the first airflow generation device 1110 to an outside of the air outlet 202. The charging groove 101 is provided with the power connection terminal (not shown), and a first end of the power connection terminal is matched with a battery pack terminal on the battery pack to realize an electrical connection with the battery pack, and a second end of the power connection terminal is electrically connected with the charging module 210.

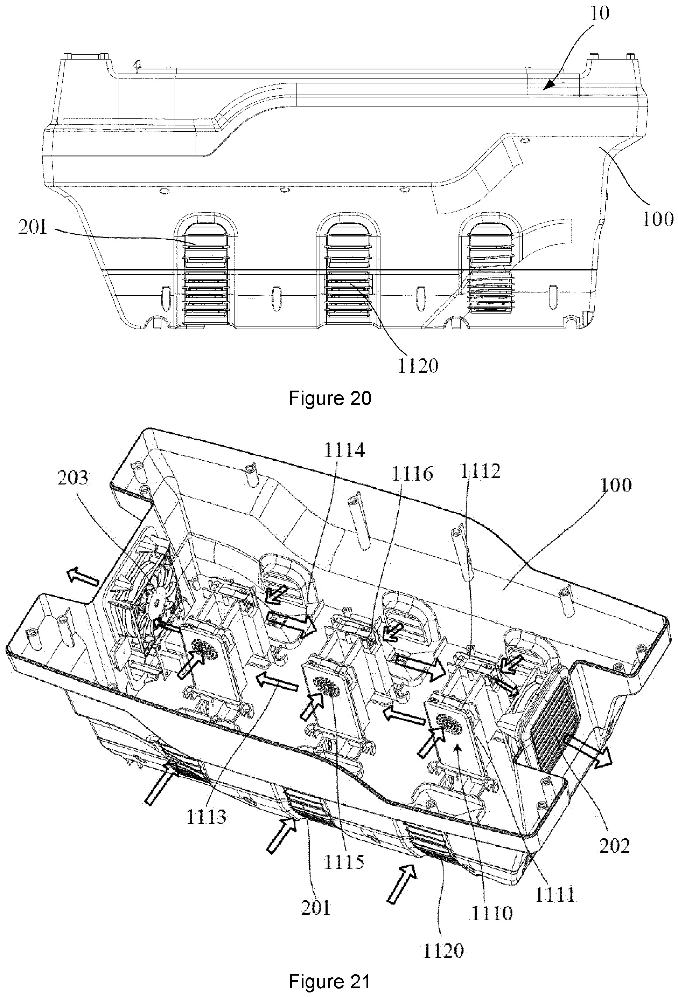

Please refer to FIG. 21. Heat dissipation airflow of the heat dissipation structure 200 is shown in FIG. 21. (Wherein, arrows indicate a direction of the airflow.) Under a suction force of the first airflow generation device 1110, part or all of the airflow entering from the air inlet 201 is inhaled by the first airflow generation device 1110 after flowing through the charging groove 101. The second airflow generation device 203 is arranged on a first flowing direction 1113 or a second flowing direction 1114 of the discharged airflow of the first airflow generation device 1110, so that the airflow discharged by the first airflow generation device 1110 is discharged to the outside of the air outlet 202, and the heat generated by the battery pack during the charging process is quickly and effectively dissipated to the outside of the housing 100.

In an embodiment of the disclosure, an airflow direction introduced by the first airflow generation device 1110 is perpendicular to an airflow direction exported by the first fan, and the first airflow generation device 1110 that dissipates heat for a same row of battery packs discharges airflows in a same direction, and the first airflow generation device 1110 that dissipate heat for two adjacent rows of battery packs discharges airflows in an opposite direction.

Please refer to FIG. 21. In an embodiment of the disclosure, the first airflow generation device 1110 includes a first fan mounting base 1111 and a first fan 1112. The first fan mounting base 1111 is arranged inside the housing 100 and located between the opposite charging grooves 101 of the two adjacent rows. The first fan 1112 is mounted on the first fan mounting base 1111, and the first fan 1112 is located above the charging groove 101. The first fan 1112 is configured to dissipate heat for the single battery pack.

The first fan mounting base 1111 is detachably mounted inside the housing 100. For example, the first fan mounting base 1111 is mounted inside the housing 100 through bolts. One fan air inlet 1115 and one fan air outlet 1116 are arranged on the first fan mounting base 1111. Wherein, the fan air inlet 1115 is arranged in an airflow inflow direction and faces the corresponding charging groove 101. Therefore, under a driving of the first fan 1112, the airflow enters from the air inlet 201, flows through the charging groove 101, enters the fan air inlet 1115, and takes away the heat generated by the battery pack.

The fan air outlet 1116 is arranged in the horizontal direction of a side of the first fan mounting base 1111, and the fan air outlets 1116 on the first fan mounting bases 1111 located in the same row have the same direction. The fan air outlets 1116 on the first fan mounting bases 1111 in the two adjacent rows are in opposite directions. For example, the fan air outlets 1116 on the first fan mounting bases 1111 in one row of the two adjacent rows are oriented in the same direction as the first flowing direction 1113, the fan air outlets 1116 on the first fan mounting bases 1111 in the other row are oriented in the same direction as the second flowing direction 1114. The first flowing direction 1113 and the second flowing direction 1114 are opposite to each other.

Therefore, directions of the fan air inlets 1115 on the first fan mounting bases 1111 of the adjacent two rows are opposite, and the directions of the fan air outlets 1116 are also opposite, which means that the airflow directions for cooling the battery pack of the adjacent two rows are opposite, thereby forming two airflow paths. Each airflow is discharged to the outside of the housing 100 by the corresponding air outlet 202, so that a heat accumulation is effectively avoided and cooling efficiency is improved.

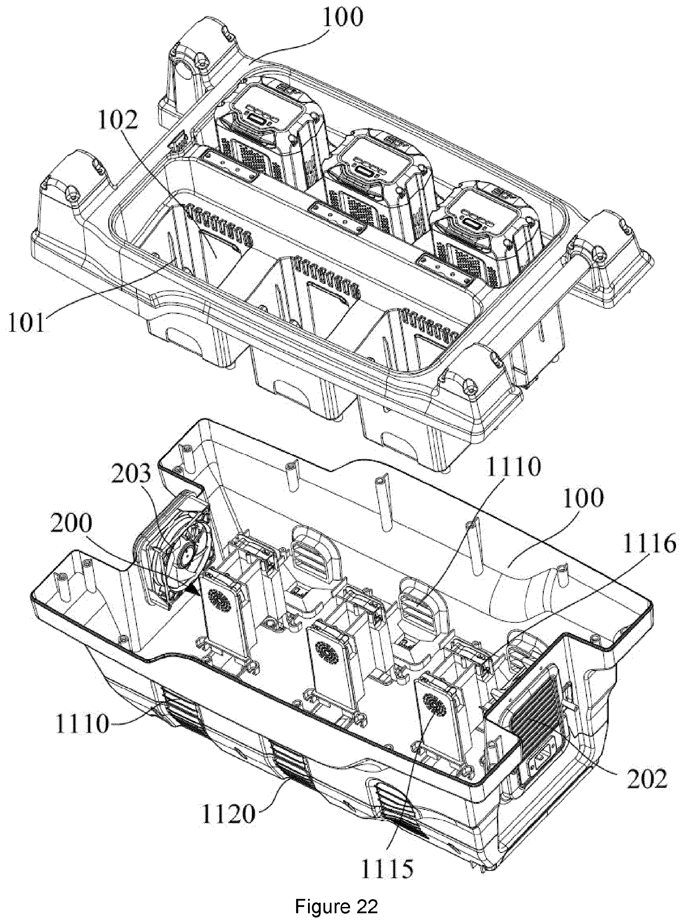

Please refer to FIG. 22. In an embodiment of the disclosure, an inner wall of the charging device 10 is provided with a mounting window 102, and the first fan mounting base 1111 is located inside the mounting window 102. The battery pack is provided with a corresponding first heat dissipation hole and a second heat dissipation hole, the first fan mounting base 1111 is correspondingly provided with the fan air inlet 1115 and the fan air outlet 1116, and a position of the fan air inlet 1115 corresponds to the first fan 1112. Part or all of the airflow inflow into the air inlet 201 flows through the first heat dissipation hole and the second heat dissipation hole, enters the fan air inlet 1115 on the first fan mounting base 1111, is sucked in by the first fan 1112, and then discharged from the fan outlet 1116.

Please refer to FIG. 19 and FIG. 21. In an embodiment of the disclosure, a number of charging grooves 101, a number of first fan mounting bases 1111, and a number of first fans 1112 are the same, for example, six. The charging device 10 is provided with the plurality of charging grooves 101, which may charge the plurality of battery packs simultaneously at one time, and improve the charging efficiency. At the same time, the first fan 1112 is arranged at a side of each charging groove 101, which means that each battery pack is provided with the corresponding first fan 1112 for heat dissipation, so it has excellent heat dissipation efficiency.

In an embodiment of the disclosure, the two first fan mounting bases 1111 located between the two opposite charging grooves 101 of the two adjacent rows are connected with each other. The two first fan mounting bases 1111 located between the two opposite charging grooves 101 of the two adjacent rows are in an integrally formed structure, and in another embodiment, the two first fan mounting bases 1111 are not limited to integrally formed structures and may also be selected as a separating type.

Please refer to FIG. 21. In an embodiment of the disclosure, the first fan 1112 is a centrifugal fan. The centrifugal fan has advantages of good ventilation and low noise, which can quickly and effectively suck the heat generated by the battery pack during the charging process from an inlet and dissipate it from an outlet.

Please refer to FIG. 21. In an embodiment of the disclosure, the second airflow generation device 203 includes a second fan. The second fan is respectively arranged at two end parts of the housing 100 and is located at an inner side of the housing 100. Axle centers of the two second fans are located on a transverse central axis of the housing. Or axis positions of the two second fans coincide axially with a center of the fan air outlet 1116 on the first fan mounting base. The second fan further discharges hot airflow discharged by the first fan 1112 to the outside of the housing 100, so that the heat of the battery pack forms a complete heat dissipation path from a place where it is generated to the outside of the housing, which avoids a situation of a heat retention and accumulation, and then ensures the excellent heat dissipation efficiency.

In an embodiment of the disclosure, the second fan is an axial flow fan. The axial flow fans have advantages of simple structure, easy installation, good ventilation effect, and low noise.

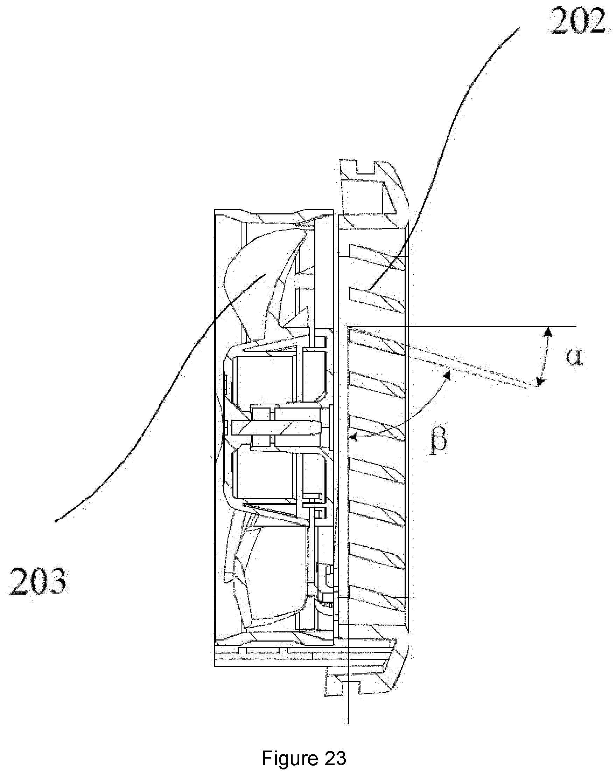

Please refer to FIG. 21 and FIG. 23. In an embodiment of the disclosure, the air outlet 202 is arranged by several mutually parallel inclined ribs, and an inclination angle of the inclined rib is from 35 degrees to 55 degrees. The inclination angle refers to the angle α of the inclined rib tilting downward from the horizontal plane, wherein the angle α is from 35 degrees to 55 degrees, or when the inclination angle β tilted outward from the vertical plane, and a sum of the angle β and the angle α is 90 degrees. This inclination angle facilitates the heat dissipation. The air outlet 202 is mounted on the housing 100 and located at a side of the second fan. The number of air outlets 202 is the same as the number of second fans.

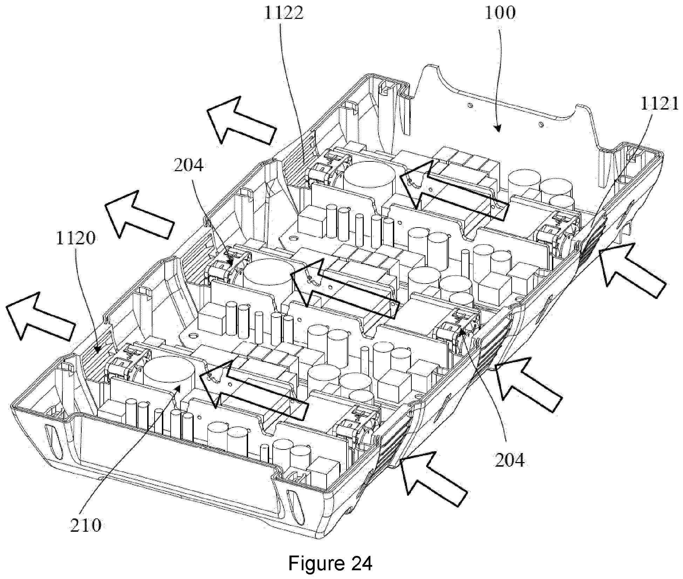

Please refer to FIG. 24. In an embodiment of the disclosure, the charging module 210 is mounted inside the housing 100. The charging module 210 is electrically connected with the power connection terminal in the charging groove 101. The heat dissipation structure 200 further includes a third airflow generation device 204. The third airflow generation device 204 is mounted between the vent 1120 and the charging module 210. The airflow is introduced from the vent 1120 on a first side by the third airflow generation device 204, and then discharged from the vent 1120 on a second side by the third airflow generation device 204. Arrows in FIG. 24 represent the flowing direction of the airflow.

Please refer to FIG. 24. In an embodiment of the disclosure, the vent 1120 includes a first ventilation window 1121 and a second ventilation window 1122. The first ventilation window 1121 is arranged opposite to the second ventilation window 1122, and part or all of the airflow entering from the first ventilation window 1121 is sucked by the third airflow generation device 204 and discharged from the second ventilation window 1122. The first ventilation window 1121 or the second ventilation window 1122 is arranged by several mutually parallel inclined ribs, and the inclination angle of the inclined rib is from 35 degrees to 55 degrees. The inclination angle refers to the angle of the inclined rib tilting downward from the horizontal plane or the angle of the inclined rib tilting outward from the vertical plane. This inclination angle facilitates the heat dissipation.

Please refer to FIG. 24. In an embodiment of the disclosure, in order to avoid a problem with the single charging module 210 during later use causing the entire circuit to become unusable, the charging device 10 of this embodiment is configured with the plurality of charging modules 210, and the adjacent two charging modules 210 are isolated by an isolation plate.

The third airflow generation device 204 includes a plurality of third fans. Two sides of each charging module 210 are respectively provided with the third fan, the flowing directions of the airflow generated by the plurality of third fans are the same, and the flowing directions of the airflow is parallel to the isolation plate. Specifically, the airflow is introduced by the third fan on one side of the charging module 210 from the first ventilation window 1121, flows to the corresponding third fan on the other side of the charging module 210, and is discharged by the third fan to the second ventilation window 1122. The advantage of the plurality of charging modules 210 is that it is convenient for later maintenance. For example, when a certain circuit fails, only the charging module 210 where the circuit is located needs to be replaced instead of replacing all the charging modules 210, thereby reducing maintenance cost. In an embodiment of the disclosure, the third fan is the axial flow fan.

It should be understood that the plurality of first fans 1112, the plurality of second fans and the plurality of third fans are included in the heat dissipation assembly of this embodiment.

In order to facilitate a zoning control and targeted heat dissipation to each area, improve heat dissipation efficiency, and also avoid a problem of insufficient heat dissipation and excessive heat dissipation, the plurality of charging modules 210 are used to control startups or shutdowns of fans located in different areas respectively, and each charging module 210 controls two fans at most. In addition, in order to facilitate an overall control of the fans, a main control module is further arranged. The main control module is electrically connected with each charging module 210 and each second fan respectively, and the main control module is used for obtaining the charging total power of all charging modules 210, and controls the startup or shutdown of the second fan according to this charging total power. It should be understood that the main control module includes the processing chip and the peripheral circuit, and each charging module 210 and the main control module drive each fan through a high-power switch tube.

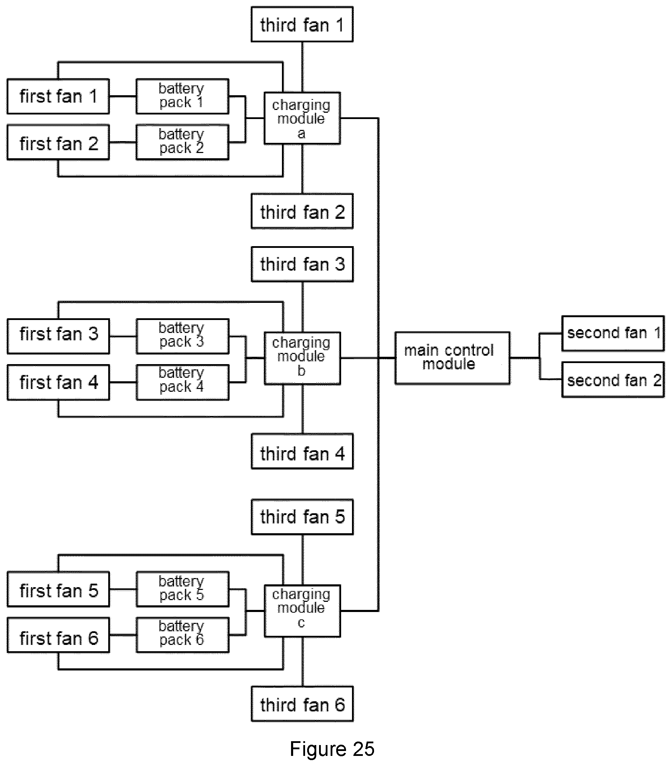

Please refer to FIG. 25. In FIG. 25, a number of battery packs accommodated by the charging device 10 is six, and three charging modules 210 are configured. Labels of each charging module 210 are respectively charging module a, charging module b and charging module c. Correspondingly, there are six first fans 1112, two the second fans, and six the third fans. Following is taking charging module a and the main control module as an example, and a control logic of each fan is described as below.

For the first fan 1112, each first fan 1112 is arranged on one side of the battery pack. After the battery pack 1 and/or the battery pack 2 are inserted into the charging groove 101, a communication connection is established with the charging module a respectively, and the first temperatures of the battery pack 1 and/or the battery pack 2 are transmitted to the charging module a in real time. If the charging module a detects that the first temperature of any battery pack is greater than the second high temperature threshold during charging, the charging is immediately stopped, the control signal is output to the first fan 1112 corresponding to the battery pack simultaneously, then the first fan 1112 is started to cool down the battery pack. The battery pack is allowed to continue charging until the first temperature of the battery pack is reduced to a normal temperature. Further, before starting charging, if the charging module a detects that the temperature of any battery pack is greater than the second high temperature threshold, the first fan 1112 corresponding to the battery pack is immediately turned on to cool this battery pack down, and the battery pack is allowed to start charging until the first temperature of the battery pack is reduced to the normal temperature.

For the third fan, the charging module a detects a working temperature of the charging module a in real time according to the second temperature obtained by the temperature sensor. When the working temperature exceeds a preset temperature, such as 95 degrees, the charging module a outputs the control signal to the third fan 1 and the third fan 2, turns on the third fan 1 and the third fan 2, and cools down the charging module a.

For the second fan, the main control module obtains the charging power of each charging module 210, and calculates the total charging power in the charging process. When the charging total power is greater than a preset power and is less than a first preset power, the main control module outputs the control signal to one second fan, and this second fan is turned on. When the charging total power is greater than the first preset power and less than a second preset power, the main control module outputs the control signal to two second fans, and the two second fans are turned on so that the hot airflow discharged by the first fan 1112 is further discharged to the outside of the housing 100. Further, the main control module further interacts with each charging module 210 in real time. Under specific conditions, for example, when the first temperature of any battery pack reaches 55 degrees, the main control module may send control signals to each charging module 210 and the second fan respectively at this moment, and all the first fans, the second fans and the third fans are turned on simultaneously, so that the hot airflow in the housing 100 may be discharged, and the temperature inside the housing is rapidly reduced.

It should be noted that, a starting temperature, the preset power, the first preset power and the second preset power of the above-mentioned fans may be set according to actual needs, which is not limited here.

It should be understood that a control logic of the charging module 210b and the charging module 210c is the same as that of the charging module 210a, which is not repeated here.

Please refer to FIG. 20. In an embodiment of the disclosure, the air inlet 201 is arranged by several mutually parallel inclined ribs. The inclination angle of the inclined rib is from 35 degrees to 55 degrees. The inclination angle refers to the angle of the inclined rib tilting downward from the horizontal plane or the angle of the inclined rib tilting downward outward from the vertical plane. This inclination angle facilitates the heat dissipation.

In addition to the inclined rib structure in the above-mentioned embodiment, the air inlet 201, the air outlet 202, the first ventilation window 1121 and the second ventilation window 1122 may also be other structures that can circulate airflow, such as through holes or gaps, etc.

It may be seen that the charging device of the embodiment may detect the first temperature of the battery pack when charging in real time, and adjust the charging current according to a range of the first temperature, which effectively improves the charging efficiency of the battery pack. At the same time, the second temperature of the charging module 210 and the total charging power of all battery packs are also detected in real time. When the first temperature, the second temperature or the total charging power exceeds a preset range, the fan at the corresponding position is turned on in time. The heat generated by the battery pack in the charging process is quickly and effectively dissipated to the outside of the housing, the duration life of the battery pack is prolonged, and a harmonious compatibility of reducing energy consumption and charging safety is realized.

Please refer to FIG. 19 through FIG. 21 and FIG. 24. The disclosure further provides a charging system. The charging system includes the charging device 10 and the battery pack. The battery pack is provided with a first heat dissipation hole and a second heat dissipation hole correspondingly. The charging device 10 includes the housing 100, the plurality of the charging grooves 101, the charging module 210 and the heat dissipation structure 200. The plurality of charging grooves 101 is arranged side by side in an inside of the housing 100, and each charging groove 101 is configured to accommodate the battery pack. The charging module 210 is arranged in the inside of the housing 100, and the charging module is arranged on it. When the battery pack is inserted into the charging groove 101, the charging module 210 is electrically connected with the power connection terminal located inside the charging groove 101, obtains the first temperature of each battery pack, and charges the battery pack according to the first temperature. The heat dissipation structure 200 is configured to dissipate heat for each battery pack, and the heat dissipation structure 200 includes the heat dissipation assembly. The charging module 210 is provided with at least one temperature sensor to obtain the second temperature of the charging module 210. The charging module 210 is further used for generating the control signal according to the first temperature and/or the second temperature, and this control signal is output to the heat dissipation assembly to control the startup or shutdown of the heat dissipation assembly, so that heat generated by the battery pack in the charging process is quickly and efficiently dissipated to the outside of the housing 100.

The heat dissipation structure 200 includes the air inlet 201, the air outlet 202, the vent 1120, the first airflow generation device 1110 and the second airflow generation device. The air inlet 201 is arranged on the housing 100 for airflow to enter. The air outlet 202 is arranged on the housing 100 for airflow to flow out. The vent 1120 are oppositely arranged on the housing 100 and located on two sides of the charging module 210.

The first airflow generation device 1110 includes the first fan mounting base 1111 and a first fan 1112. The first fan mounting base 1111 is arranged in the housing 100 and located between the two opposite charging grooves 101 of the two adjacent rows. The first fan 1112 is mounted on the first fan mounting base 1111, and the first fan 1112 is located above the charging groove 101. The first fan 1112 is configured to dissipate heat for the single battery pack. The airflow flowing from the air inlet 201 partially flows through the first heat dissipation hole and the second heat dissipation hole to dissipate heat for the battery pack under a driving of the first airflow generation device 1110, and is discharged by the first airflow generation device.

The second airflow generation device 203 includes the second fan. The second fan is respectively arranged at the two end parts of the housing 100 and is located at an inner side of the housing 100. Axle centers of the two second fans are located on the transverse central axis of the housing. Or axis positions of the two second fans coincide axially with the center of the fan air outlet 1116 on the first fan mounting base. The second fan is located in a flowing direction of the discharged airflow by the first fan 1112, and the second fan discharges the airflow introduced by the first fan 1112 to an outside of the air outlet 202.

The heat dissipation structure 200 further includes the third airflow generation device 204. The third airflow generation device 204 is mounted between the vent 1120 and the charging module 210. The airflow is introduced from the vent 1120 on one side by the third airflow generation device 204, and then discharged from the vent 1120 on the other side by the third airflow generation device 204. Arrows in FIG. 24 represent the flowing direction of the airflow.

The third airflow generation device 204 includes the third fan. Each charging module 210 is provided with the third fan on both sides, and the flowing directions of the airflow produced by the plurality of third fans are the same. In an embodiment of the disclosure, the third fan is the axial flow fan.

It should be understood that the first fans 1112, the second fans and the third fans are included in the heat dissipation assembly of this embodiment.

The charging groove 101 is provided with the power connection terminal (not shown), and the first end of the power connection terminal is matched with the battery pack terminal on the battery pack to realize the electrical connection with the battery pack, and the second end of the power connection terminal is electrically connected with the charging module 210.

In summary, with the charging device and the charging system of the disclosure, the bottom of the housing 100 is provided with the first wheel 400, the lifting handle 300 can enable the charging device to move by a rolling of the first wheel 400, and the first wheel 400 and the supporting assembly 500 can be matched with each other to enable the charging device to be placed smoothly. The drainage assembly 800 can effectively play a role of waterproofing, and the risk of leakage is reduced. The shockproof assembly may effectively reduce vibrations during handling. Therefore, the charging device of the disclosure can improve a problem that conventional charging devices are difficult to handle. On the other hand, the charging device and the charging system of the disclosure may detect the first temperature of the battery pack when charging in real time, and adjust the charging current according to the range of the first temperature, which effectively improves the charging efficiency of the battery pack. At the same time, the second temperature of the charging module 210 and the total charging power of all battery packs are also detected in real time. When the first temperature, the second temperature or the total charging power exceeds the preset range, the fan at the corresponding position is turned on in time. The heat generated by the battery pack in the charging process is quickly and effectively dissipated to the outside of the housing, the duration life of the battery pack is prolonged, and the harmonious compatibility of reducing energy consumption and charging safety is realized. Therefore, the disclosure effectively overcomes some practical problems in the prior art, thereby having high utilization value and use significance.

The above embodiments only illustrate principles and effects of the disclosure, but are not intended to limit the disclosure. Anyone familiar with this technology may modify or change the above embodiments without departing from a scope of the disclosure. Therefore, all equivalent modifications or changes made by those with ordinary knowledge in the technical field without departing from the technical ideas disclosed in the disclosure shall still be covered by the claims of the disclosure.

## Claims

1. A charging device, comprising:
a housing;
a plurality of charging grooves, arranged side by side inside the housing to accommodate an inserted battery pack;
a handle, for a user to hold and movably connected with the housing;
a first wheel, rotatably arranged at a bottom of the housing, and
a supporting assembly, arranged at the bottom of the housing; wherein
when the charging device is pulled, the handle is held, the charging device is inclined and slides relative to a ground by the first wheel, and when the charging device is placed horizontally, the first wheel and the supporting assembly are in contact with the ground.

2. The charging device according to claim 1, wherein, the housing is configured to a plurality of layers, at least two layers of the housing are provided with a corresponding vent sash, and a drainage assembly is arranged inside the layer corresponding to the vent sash.

3. The charging device according to claim 2, wherein, the at least two layers of the housing are arranged up and down to enable the drainage assemblies corresponding to each layer of the housing to be buckled up and down with each other, and a water outlet of the drainage assembly at a lower layer is communicated with an outside.

4. The charging device according to claim 2, wherein, each of the vent sash comprises a plurality of mutually parallel inclined ribs arranged at equal intervals, and the inclined ribs are inclined downward by 35° to 50° from a horizontal plane.

5. The charging device according to claim 1, wherein, a limiting structure is arranged between the handle and the housing, the limiting structure comprises a first limiting component and a second limiting component, the first limiting component is arranged on the handle, and the second limiting component is arranged on the housing and is matched with the first limiting component.

6. The charging device according to claim 1, wherein, the supporting assembly is a bracket, and a first side of the bracket is in contact with the ground, and a second side of the bracket is connected with the bottom of the housing.

7. The charging device according to claim 1, wherein, the supporting assembly is a second wheel, and the second wheel is in a same direction with the first wheel and is arranged at intervals with the first wheel.

8. The charging device according to claim 1, wherein, the charging device further comprises an auxiliary assembly, the auxiliary assembly is arranged at the bottom of the housing, when lifting, one end of the auxiliary assembly is in contact with the ground, and the end in contact with the ground is used as a fulcrum to cooperate with an external force to lift the charging device.

9. The charging device according to claim 1, further comprising:
a charging module, arranged in the housing, configured to obtain a first temperature of each battery pack after communicating with the inserted battery pack, and charge the battery pack according to the first temperature;
a temperature sensor, arranged on the charging module and configured to obtain a second temperature of the charging module; and
a heat dissipation assembly, arranged inside the housing; wherein
the charging module is further configured to generate a control signal to the heat dissipation assembly according to the first temperature and/or the second temperature, and control a startup or shutdown of the heat dissipation assembly.

10. The charging device according to claim 9, wherein, the charging module charges each battery pack according to the first temperature and is configured to:
start charging when the first temperature is greater than a low temperature threshold;
charge with a first current when the first temperature rises to a first temperature range;
charge with a second current when the first temperature rises to a second temperature range;
maintain a current total charging power unchanged and charge the battery pack with the first current when the first temperature of any battery pack rises to a first high temperature threshold; and
stop charging and alarm when the first temperature of any battery pack rises to a second high temperature threshold.

11. The charging device according to claim 10, wherein, the charging device is configured with a plurality of the charging modules, and each charging module is communicated with two battery packs at most and charges the at most two battery packs according to the first temperature of each battery pack obtained, wherein, each charging module is configured to
evenly distribute a charging power when an electric quantity difference between the two battery packs is less than a preset electric quantity, and
charge the battery pack having larger electric quantity preferentially and distribute larger power to the battery pack having larger electric quantity when the electric quantity difference between the two battery packs is greater than the preset electric quantity.

12. The charging device according to claim 9, wherein, the heat dissipation assembly comprises:
a first fan, mounted between the opposite charging grooves in two adjacent rows, configured to be started or shut down according to the control signal generated from the first temperature, and each first fan being configured to introduce airflow outside the housing into the charging groove through an air inlet on the housing for heat dissipation of a single battery pack;
a second fan, respectively arranged at two end parts of the housing, located on an inner side of the housing, and configured to export the airflow discharged by the first fan to an outside of the housing through an air outlet on the housing; and
a third fan, respectively arranged on two sides of the charging module, and configured to be started or shut down according to the control signal generated from the second temperature.

13. The charging device according to claim 12, wherein, an airflow direction introduced by the first fan is perpendicular to an airflow direction exported by the first fan and the first fans that dissipate heat for a same row of battery packs discharge airflows in a same direction, and the first fans that dissipate heat for two adjacent rows of battery packs discharge airflows in an opposite direction.

14. The charging device according to claim 12, wherein, the housing is further provided with:
vents, oppositely arranged on the housing and located at two sides of the charging module, the third fan being mounted between the vent and the charging module, and the airflow being introduced by the third fan from the vent on a first side and then exported by the third fan from the vent on a second side.

15. A charging system, comprising:
a battery pack; and
a charging device, configured to charge the battery pack, comprising:
a housing;
a plurality of charging grooves, arranged side by side inside the housing to accommodate the inserted battery pack;
a handle, for a user to hold and movably connected with the housing;
a first wheel, rotatably arranged at a bottom of the housing, and
a supporting assembly, arranged at the bottom of the housing; wherein
when the charging device is pulled, the handle is held, the charging device is inclined and slides relative to a ground by the first wheel, and when the charging device is placed horizontally, the first wheel and the supporting assembly are in contact with the ground.
